(19) Europäisches Patentamt European Patent Office Office européen des brevets

(11) **EP 3 053 163 B1**

(12) **FASCICULE DE BREVET EUROPEEN**

(45) Date de publication et mention de la délivrance du brevet:
**09.11.2022 Bulletin 2022/45**

(21) Numéro de dépôt: **14796207.0**

(22) Date de dépôt: **26.09.2014**

(51) Classification Internationale des Brevets (IPC):
**G10L 19/04** *(2013.01)* **G10L 19/24** *(2013.01)*
**H03H 17/06** *(2006.01)*

(52) Classification Coopérative des Brevets (CPC):
**G10L 19/04;** G10L 19/24; H03H 17/0621

(86) Numéro de dépôt international:
**PCT/FR2014/052430**

(87) Numéro de publication internationale:
**WO 2015/044609 (02.04.2015 Gazette 2015/13)**

(54) **RE-ECHANTILLONNAGE D'UN SIGNAL AUDIO POUR UN CODAGE/DECODAGE A BAS RETARD**

WIEDERABTASTUNG EINES TONSIGNALS ZUR CODIERUNG/DECODIERUNG MIT GERINGER VERZÖGERUNG

RESAMPLING AN AUDIO SIGNAL FOR LOW-DELAY ENCODING/DECODING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.09.2013 FR 1359456**

(43) Date de publication de la demande:
**10.08.2016 Bulletin 2016/32**

(60) Demande divisionnaire:
**17206561.7 / 3 330 964**

(73) Titulaire: **Koninklijke Philips N.V.**
**5656 AG Eindhoven (NL)**

(72) Inventeurs:
• **KOVESI, Balazs**
  **F-22300 Lannion (FR)**
• **RAGOT, Stéphane**
  **F-22300 Lannion (FR)**

(74) Mandataire: **Philips Intellectual Property & Standards**
**High Tech Campus 52**
**5656 AG Eindhoven (NL)**

(56) Documents cités:
**WO-A1-2012/103686     US-A1- 2013 096 913**

## Description

La présente invention se rapporte au traitement d'un signal audiofréquence pour sa transmission ou son stockage. Plus particulièrement, l'invention se rapporte à un changement de fréquence d'échantillonnage lors d'un codage ou d'un décodage du signal audiofréquence.

De nombreuses techniques existent pour compresser (avec perte) un signal audiofréquence comme la parole ou la musique. Le codage peut s'effectuer directement à la fréquence d'échantillonnage du signal d'entrée, comme par exemple dans les recommandations IUT-T G.711 ou G.729 où le signal d'entrée est échantillonné à 8 kHz et le codeur et décodeur fonctionnent à cette même fréquence.

Cependant, certaines méthodes de codage utilisent un changement de fréquence d'échantillonnage, par exemple pour réduire la complexité du codage, adapter le codage en fonction des différentes sous-bandes fréquentielles à coder, ou convertir le signal d'entrée pour qu'il corresponde à une fréquence d'échantillonnage interne prédéfinie du codeur.

Dans le codage en sous-bandes défini dans la recommandation UIT-T G.722, le signal d'entrée à 16 kHz est divisé en 2 sous-bandes (échantillonnées à 8 kHz) qui sont codées séparément par un codeur de type MICDA (pour "Modulation par Impulsion et Codage Différentiel adaptatif", ADPCM en anglais). Cette division en 2 sous-bandes est effectuée par un banc de filtres miroirs en quadratique à réponse impulsionnelle finie (FIR en anglais pour "Finite Impulse Response"), d'ordre 23 qui occasionne en théorie un retard d'analyse-synthèse (codeur+décodeur) de 23 échantillons à 16 ms ; ce banc de filtre est mis en œuvre avec une réalisation en polyphasé. La division en deux sous-bandes dans G.722 permet d'allouer de façon prédéterminée des débits différents aux deux sous-bandes en fonction de leur importance perceptuelle a priori et aussi de réduire la complexité totale de codage en exécutant deux codeurs de type MICDA à une fréquence plus faible. Par contre, elle induit un retard algorithmique par rapport à un codage MICDA direct.

Différentes méthodes de changement de fréquence d'échantillonnage, encore appelé ré-échantillonnage, d'un signal numérique sont connues, en utilisant par exemple et de façon non exhaustive, un filtre FIR (pour "Finite Impulse Response" en anglais, ou Réponse Impulsionnelle finie en français), un filtre IIR (pour "Infinité Impulse response" en anglais, ou Réponse Impulsionnelle infinie en français) ou une interpolation polynômiale (dont les splines). Une revue des méthodes classiques de ré-échantillonnage se trouve par exemple dans l'article R.W. Schafer, L.R. Rabiner, A Digital Signal Processing Approach to Interpolation, Proceedings of the IEEE, vol. 61, no. 6, June 1973, pp. 692 - 702

L'avantage du filtre FIR (symétrique) tient à sa mise en œuvre simplifiée et - sous certaines conditions - à la possibilité d'assurer une phase linéaire. Un filtrage à phase linéaire permet de préserver la forme d'onde du signal d'entrée, mais il peut aussi s'accompagner d'un étalement temporel (« ringing ») pouvant créer des artéfacts de type pré-échos sur des transitoires. Cette méthode occasionne un retard (qui est fonction de la longueur de la réponse impulsionnelle), en général de l'ordre de 1 à quelques ms pour assurer des caractéristiques de filtrage adéquates (ondulation dans la bande passante, niveau de réjection suffisant pour supprimer le repliement ou les images spectrales...).

L'alternative d'un ré-échantillonnage par filtre IIR conduit en général à une phase non linéaire, à moins de compenser la phase par un étage supplémentaire de filtrage passe-tout, comme décrit par exemple dans l'article P.A. Regalia, S.K. Mitra, P.P. Vaidyanathan, The Digital All-Pass Filter: A Versatile Signal Processing Building Block, Proceedings of the IEEE, vol. 76, no. 1, Jan. 1988, avec un exemple de réalisation dans la routine 'iirgrpdelay' du logiciel MATLAB; un filtre IIR est en général d'ordre moins élevé mais plus complexe à mettre en œuvre en virgule fixe, les états (ou mémoires) du filtre pouvant atteindre des valeurs de grande dynamique pour la partie récursive, et ce problème est amplifié si une compensation de phase par filtrage passe-tout est utilisée.

US2013/096913A1 et WO2012/103686A1 divulguent des codeurs de parole à codage prédictif linéaire.

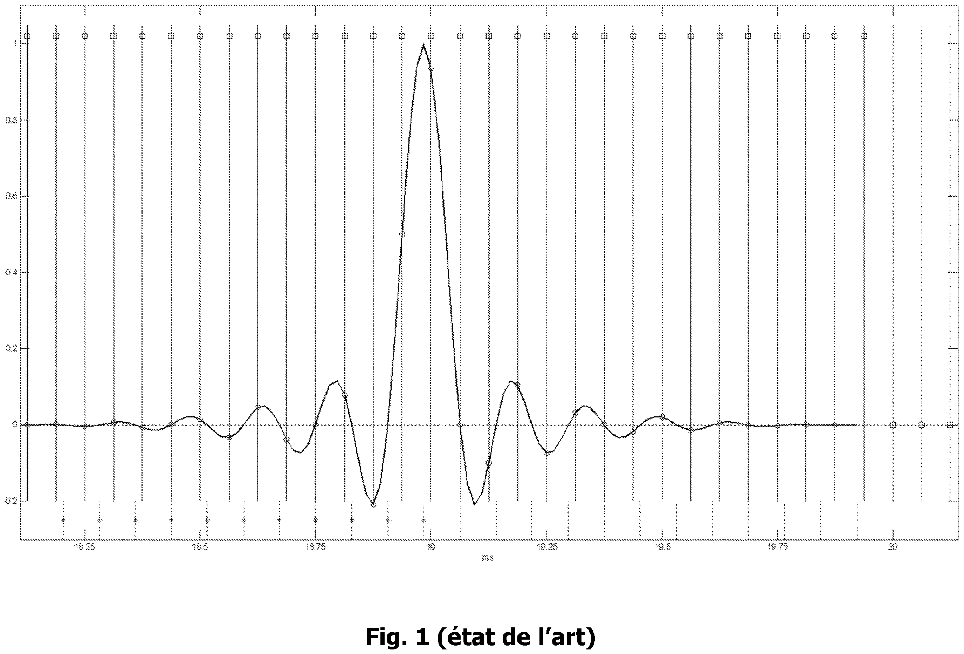

La **figure 1** illustre un exemple de sous-échantillonnage par un ratio de 4/5 avec un filtre FIR de longueur de 2*60+1=121 coefficients à 64 kHz pour passer de 16 kHz à 12.8 kHz. Les abscisses représentent le temps (ramené en ms pour représenter les signaux cadencés à fréquences différentes) et les ordonnées les amplitudes. Les carrés en haut représentent les positions temporelles des échantillons du signal d'entrée à 16 kHz ; on suppose ici que ces échantillons correspondent à la fin d'une trame de 20 ms. Les lignes verticales continues marquent les instants d'échantillonnage correspondants à 16 kHz. En bas de la figure, les lignes verticales en pointillés marquent les instants d'échantillonnage correspondants à 12.8 kHz et les étoiles symbolisent les échantillons de sortie à 12.8 kHz. On a également représenté la réponse impulsionnelle (symétrique) de 121 coefficients d'un filtre FIR à 64 kHz, cette réponse est positionnée pour calculer le dernier échantillon de la trame courante à 12.8 kHz (la position du maximum de la réponse impulsionnelle est alignée avec cet échantillon). Les ronds montrent les valeurs utilisées (correspondants au moment d'échantillonnage d'entrée) dans une représentation en polyphase ; pour obtenir l'échantillon de sortie on multiplie ces valeurs par l'échantillon d'entrée correspondante et on additionne ces résultats. On remarque sur cette figure que 12 échantillons (jusqu'à la fin de la trame d'entrée) à 12.8 kHz ne peuvent pas être calculés exactement parce que les échantillons d'entrée après la fin de la trame courante (début de la trame suivante) ne sont pas encore connus ; le retard de sous-échantillonnage dans les conditions de la figure 1 est de 12 échantillons, soit 12/12.8 = 0.9375 ms.

Des techniques de réduction du retard introduit par les changements de fréquence d'échantillonnage de type FIR existent.

Dans la norme 3GPP AMR-WB (aussi définie comme la recommandation UIT-T G.722.2), le signal d'entrée échantillonné à 16 kHz est sous-échantillonné à une fréquence interne de 12.8 kHz avant d'appliquer un codage de type CELP ; le signal décodé à 12.8 kHz est ensuite ré-échantillonné à 16 kHz et combiné avec un signal de bande haute.

L'avantage de passer par une fréquence intermédiaire de 12.8 kHz est qu'elle permet de réduire la complexité du codage CELP et aussi d'avoir une longueur de trame multiple d'une puissance de 2, ce qui facilite le codage de certains paramètres CELP. La méthode utilisée est un ré-échantillonnage classique d'un facteur 4/5 par filtre FIR (de 121 coefficients à 64 kHz), avec une réalisation en polyphase pour minimiser la complexité.

En théorie, ce ré-échantillonnage au codeur et au décodeur AMR-WB devrait occasionner un retard d'une manière similaire au traitement représenté à la figure 1. Dans le cas du codec AMR-WB, avec un filtre FIR de 121 coefficients, le retard total devrait être en théorie de 2x60 échantillons à 64 kHz soit 2x15 échantillons à 16 kHz ou 1.875 ms ; en fait, une technique spécifique est mise en œuvre au codeur AMR-WB pour éliminer (compenser) le retard associé dans la partie codeur uniquement et donc diviser par 2 le retard effectif.

Cette méthode de compensation est décrite dans la norme 3GPP TS 26.190, Clause 5.1 et dans la recommandation UIT-T G.722.2, Clause 5.1. La méthode de compensation de retard de filtrage FIR consiste à ajouter, pour chaque nouvelle trame échantillonnée à 16 kHz, à convertir à 12.8 kHz, un nombre prédéterminé de zéros à la fin de la trame courante. Ces zéros sont définis à la fréquence d'échantillonnage d'entrée et leur nombre correspond au retard du filtre FIR de ré-échantillonnage à cette fréquence (soit 15 zéros ajoutés à 16 kHz). Le ré-échantillonnage est mis en œuvre par trame de 20 ms (320 échantillons). Le ré-échantillonnage dans le codeur AMR-WB est donc équivalent à compléter la trame d'entrée de 320 échantillons à gauche (vers le passé) par 30 échantillons de la fin de trame précédente (mémoire de ré-échantillonnage) et à droite par 15 zéros pour former un vecteur de 30+320+15=365 échantillons, qui est ensuite ré-échantillonné avec un facteur 4/5. Le filtre FIR peut ainsi être mis en œuvre avec une phase nulle, donc sans retard, puisqu'on rajoute un signal futur nul. En théorie le ré-échantillonnage FIR par un facteur 4/5 s'effectue selon les étapes suivantes :

- Sur-échantillonnage par 4 (de 16 kHz à 64 kHz) par ajout de 3 échantillons à 0 après chaque échantillon d'entrée
- Filtrage passe-bas de fonction de transfer $H_{decim}(z)$ de type FIR symétrique d'ordre 120 à 64 kHz
- Sous-échantillonnage par 5 (de 64 kHz à 12.8 kHz) en ne gardant qu'un échantillon sur cinq du signal filtré passe-bas.

En pratique, ce ré-échantillonnage est mis en œuvre de façon équivalente suivant une réalisation optimisée en polyphase sans calculer le signal intermédiaire à 64 kHz et sans concaténer le signal à convertir avec des zéros (voir le fichier « decim54.c » du code source du codec AMR-WB); le filtrage FIR pour chaque « phase » est équivalent à un filtre FIR d'ordre 24 à 12.8 kHz avec un retard de 12 échantillons à 12.8 kHz, soit 0.9375 ms.

Le résultat du ré-échantillonnage FIR de chaque trame de 20 ms de 16 kHz à 12.8kHz est identique à un ré-échantillonnage effectué sur le signal d'entrée « complet » (non découpé en trames), sauf pour les 12 derniers échantillons de chaque trame résultante à 12.8 kHz qui comportent une erreur due à l'utilisation d'un bloc de zéros comme signal futur au lieu du « vrai » signal futur qui n'est disponible qu'à la trame suivante. En fait, les zéros introduits simulent le cas d'un signal d'entrée nul dans la trame suivante.

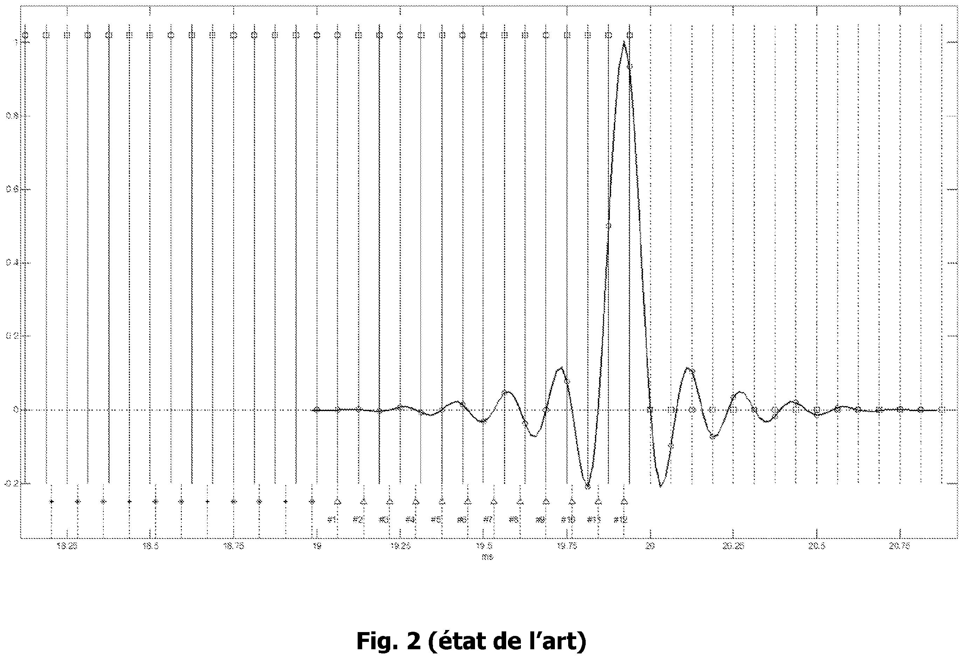

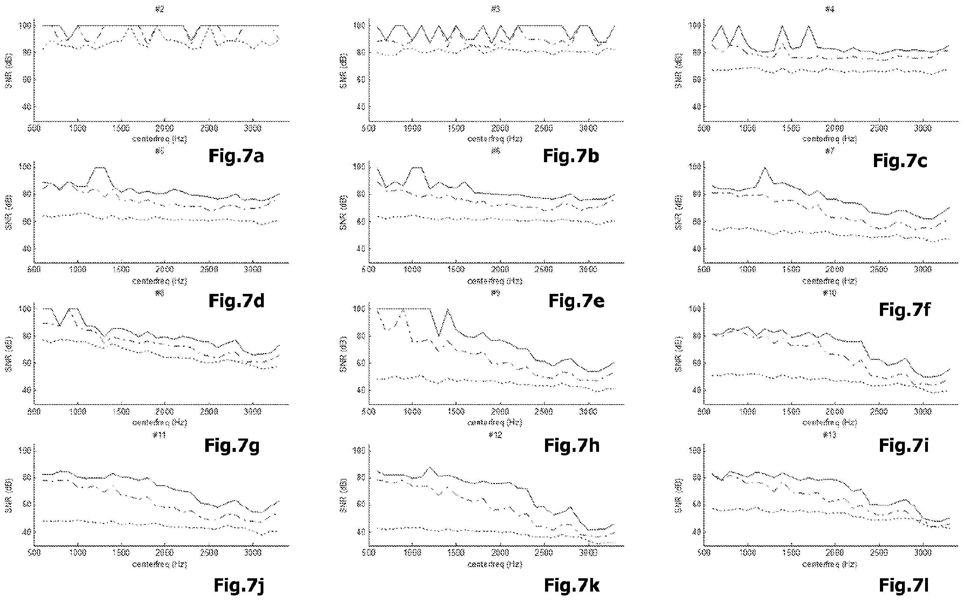

Ce traitement est illustré à la fin d'une trame de 20 ms en **figure 2** qui représente les derniers échantillons d'entrée à 16 kHz par les carrés en haut ; les lignes verticales marquent les moments d'échantillonnage correspondants à 16 kHz. En bas de la figure, les étoiles symbolisent les échantillons de sortie à 12.8 kHz qui peuvent être obtenus par sous-échantillonnage classique avec retard de 12 échantillons. Ensuite, les triangles en bas correspondent aux 12 échantillons à 12.8 kHz obtenus en utilisant au moins un échantillon de valeur nulle ajouté à la fin de la trame pour pouvoir continuer le filtrage et réduire le retard. Ces échantillons sont numérotés de #1 à #12 en fonction de leur position par rapport à la fin de la sortie obtenu avec un filtrage classique. On a également représenté la réponse impulsionnelle du filtre à 64 kHz utilisé dans la position correspondant au dernier échantillon de sortie à 12.8 kHz (le maximum de la réponse impulsionnelle est aligné avec cet échantillon). Les ronds montrent les valeurs utilisées (correspondant au moment d'échantillonnage d'entrée) dans la représentation en polyphase ; pour obtenir l'échantillon de sortie on multiplie ces valeurs par l'échantillon d'entrée correspondant ou par 0 pour les valeurs après la fin de la trame et on additionne ces résultats. On y observe que pour ce dernier échantillon presque la moitié des échantillons utilisés de la réponse impulsionnelle est multiplié par les zéros ajoutés, ce qui introduit donc une erreur d'estimation importante. On comprend aussi que l'erreur des premiers échantillons générés après le filtrage classique (c.à.d. avec uniquement le vrai signal d'entrée) est faible (le poids de la réponse impulsionnelle à son extrémité est faible) et plus on s'éloigne du filtrage classique plus l'erreur est grande (le poids de la réponse impulsionnelle étant alors plus important). On pourra observer cela sur les résultats des figures 7.

La méthode de compensation de retard utilisé dans le codec AMR-WB, où des zéros sont ajoutés à la fin de chaque bloc (ou trame) de 20 ms à ré-échantillonner, permet d'éliminer le retard de ré-échantillonnage au codeur, mais elle n'est pas satisfaisante en général quand les valeurs générées à la fin de la trame courante (avec des zéros ajoutés à l'entrée) sont codées directement et ne sont pas remplacées par les vraies valeurs une fois le signal d'entrée de la trame suivante connu. En fait ces erreurs régulières à la fin de chaque trame génèrent des discontinuités périodiques lors du passage au vrai signal de sortie au début de trame suivante. Ces discontinuités sont souvent audibles et très gênantes. C'est pourquoi la compensation de retard n'est appliquée qu'au codeur et uniquement dans la partie signal futur dit « lookahead » en anglais, et non au décodeur AMR-WB.

En fait, dans le codeur AMR-WB, chaque nouvelle trame d'entrée de 20 ms à 16 kHz correspond à un segment temporel correspondant aux derniers 15 ms de la trame courante à coder par modèle ACELP et 5 ms de signal futur ("lookahead" en anglais). Les premiers 5 ms de la trame courante à coder ont été déjà reçus mémorisés comme "lookahead" du segment précédent. Les 12 derniers échantillons obtenus après ré-échantillonnage de 16 à 12.8 kHz au codeur correspondent donc aux derniers échantillons du signal futur de 5 ms à 12.8 kHz. Par la suite, la trame courante de 20 ms à 12.8 kHz (soit 256 échantillons) et les 5 ms de signal futur (soit 64 échantillons) est complétée par 5 ms de signal original passé ("loopback" en anglais) pour former le buffer d'analyse LPC de 384 échantillons (30 ms) qui est pondéré par une fenêtre d'analyse LPC de même longueur.

Les 12 derniers échantillons du "lookahead" à 12.8 kHz comportant une erreur de ré-échantillonnage ont un poids relatif très faible dans la fenêtre servant à la prédiction linéaire (LPC), et a fortiori ils n'ont d'impact que sur l'enveloppe LPC estimée et cet impact est très négligeable. Il est important de noter que les 12 échantillons erronés sont remplacés par les valeurs « exactes » de ré-échantillonnage à la trame suivante, l'erreur n'est donc présente que temporairement dans la trame courante pour le signal futur (lookahead) et n'impacte que l'analyse LPC. Ainsi, la technique de compensation de retard du codeur AMR-WB n'impacte pas le codage de la forme d'onde du signal dans la trame courante dans le codec AMR-WB. On appelle par la suite ce mode : "utilisation par trame avec signal futur". Les échantillons ainsi générés sont uniquement utilisés de façon temporaire pour des calculs intermédiaires (analyse LPC) et sont remplacés par les échantillons correctement ré-échantillonnés quand le signal de la trame suivante est connu. On remarque que dans cette configuration, pour une trame de sortie de longueur *lg_out* pour chaque trame, on génère *lg_out +12* échantillons par le ré-échantillonnage.

Cette technique de compensation de retard utilisée au codeur AMR-WB n'est pas appliquée au décodeur AMR-WB

Ainsi, le codec (codeur+décodeur) a un retard algorithmique total de 25.9375 ms dû au codeur (20 ms trame + 5 ms de lookahead) et au ré-échantillonnage au décodeur (0.9375 ms).

La technique de compensation de retard du codeur AMR-WB ne pourrait pas être utilisée pour réduire le retard de filtrage QMF du codec G.722, car elle dégraderait fortement la qualité du signal codé. En effet dans le codec G.722 les échantillons résultant du filtrage (les signaux en bande basse et bande haute) constituent directement les signaux d'entrée des 2 sous-codecs MICDA qui opèrent sans "lookahead" et qui ne permettent pas de corriger ces valeurs d'une trame à l'autre. On appellera par la suite ce mode: "utilisation trame par trame continue".

La présente invention vient améliorer la situation de l'état de l'art.

Elle propose à cet effet, un procédé de ré-échantillonnage d'un signal audiofréquence dans un codage ou décodage de signal audiofréquence. Le procédé est tel qu'il comporte les étapes suivantes par bloc de signal à ré-échantillonner:

- détermination par prédiction linéaire adaptative d'un nombre d'échantillons de signal futur, ce nombre étant défini en fonction d'un retard de ré-échantillonnage choisi ;
- construction d'un vecteur support de ré-échantillonnage à partir au moins des échantillons du bloc courant et des échantillons déterminés de signal futur;
- application d'un filtre de ré-échantillonnage sur les échantillons du vecteur support de ré-échantillonnage.

Ainsi, le ré-échantillonnage selon l'invention permet de diminuer le retard de ré-échantillonnage par filtre (par bloc ou par trame), tout en gardant une performance très proche d'un ré-échantillonnage continu. La prédiction du signal futur dans chaque bloc ou trame permet d'avoir des échantillons plus proches des échantillons réels que si ces échantillons futurs étaient fixés à une valeur nulle. La performance du processus de ré-échantillonnage pour ces derniers échantillons est donc meilleure.

Ce procédé de ré-échantillonnage est de plus adaptatif puisqu'il est possible d'adapter le nombre d'échantillons de signal futur à prendre en compte en fonction du retard souhaité. Pour un ré-échantillonnage sans retard, le nombre d'échantillons de signal futur à déterminer correspond alors au retard du filtre de ré-échantillonnage. Si un retard plus faible que le retard du filtre est toléré, alors le nombre d'échantillons de signal futur peut correspondre à seulement une partie du retard du filtre de ré-échantillonnage.

L'adaptation du retard de ré-échantillonnage étant effectué par bloc de signal, il est alors possible de commuter facilement, d'un bloc à un autre ou d'une trame à une autre, différentes configurations de ré-échantillonnage (dont le filtre FIR utilisé à cette fin) ou de commuter un codage direct d'une trame donnée à une certaine fréquence d'échantillonnage vers un codage de la trame suivante avec ré-échantillonnage, ou vice-versa.

Les différents modes particuliers de réalisation mentionnés ci-après peuvent être ajoutés indépendamment ou en combinaison les uns avec les autres, aux étapes du procédé de ré-échantillonnage défini ci-dessus.

Dans un mode simple de réalisation, l'étape de détermination par prédiction linéaire adaptative comprend les étapes suivantes:

- obtention de coefficients d'un filtre de prédiction linéaire d'ordre prédéterminé;
- obtention des échantillons de signal futur par application du filtre de prédiction obtenu à un signal d'excitation de valeur nulle.

Dans un mode de réalisation particulier, les coefficients du filtre de prédiction linéaire sont obtenus par lecture de paramètres mémorisés à l'étape de codage ou de décodage.

Ainsi, lorsque le module de codage, indépendant du dispositif de ré-échantillonnage, comporte une analyse LPC qui détermine déjà les paramètres du filtre de prédiction, il n'est pas nécessaire de recalculer ces paramètres lors du procédé de ré-échantillonnage. Il suffit juste de lire les paramètres qui ont été mémorisés (de façon quantifiées ou non).

Dans un autre mode de réalisation les coefficients du filtre de prédiction linéaire sont obtenus par analyse à partir au moins des échantillons du bloc courant.

L'analyse LPC se fait alors directement dans le dispositif de ré-échantillonnage.

Dans un exemple de réalisation, la prédiction linéaire est effectuée sur un signal audiofréquence sur lequel un traitement de préaccentuation a été effectué.

La préaccentuation permet d'assurer une meilleure stabilité numérique dans une mise en œuvre en virgule fixe, en particulier pour les signaux ayant une forte pente et dynamique spectrale. Elle réduit la dynamique spectrale du signal, la distribution de la puissance du signal sur les bandes de fréquences devient ainsi plus homogène après la préaccentuation. Les paramètres de modélisation après préaccentuation ont une plus faible dynamique, et il est plus facile d'assurer la stabilité du système et plus facile également d'implémenter l'algorithme utilisant ce modèle avec une arithmétique à virgule fixe.

Dans des modes possibles de réalisation, la prédiction linéaire adaptative est une prédiction parmi l'une des méthodes suivantes:

- prédiction linéaire à court terme;
- prédiction linéaire à long terme;
- combinaison de prédiction linéaire à court terme et de prédiction linéaire à long terme;
- processus de dissimulation de trame effacée.

Ainsi, tout type de prédiction plus ou moins précise est possible pour la mise en œuvre du procédé tout en assurant une efficacité en termes de rapport signal à bruit intéressante.

La présente invention vise également un dispositif de ré-échantillonnage d'un signal audiofréquence dans un codeur ou décodeur de signal audiofréquence. Le dispositif est tel qu'il comporte:

- un module de prédiction linéaire adaptative apte à déterminer par bloc de signal, un nombre d'échantillons de signal futur défini en fonction d'un retard de ré-échantillonnage choisi;
- un module de construction d'un vecteur support de ré-échantillonnage à partir au moins des échantillons du bloc courant et des échantillons déterminés de signal futur;
- un filtre de ré-échantillonnage appliqué sur les échantillons du vecteur support de ré-échantillonnage.

Ce dispositif présente les mêmes avantages que le procédé décrit précédemment, qu'il met en œuvre.

Dans un mode de réalisation particulier, le module de prédiction linéaire adaptative coopère avec un module d'analyse par prédiction compris dans le module de codage ou de décodage par prédiction, du codeur ou décodeur.

Ainsi, la complexité du dispositif de ré-échantillonnage est réduite puisqu'il n'a pas besoin de comporter de module d'analyse LPC. Les paramètres issus du module d'analyse du module de codage ou de décodage sont mémorisés lors du codage ou du décodage et peuvent ainsi servir lors du ré-échantillonnage.

La présente invention vise également un codeur et un décodeur de signal audiofréquence comportant au moins un dispositif de ré-échantillonnage tel que décrit.

Dans un mode de réalisation particulier, le codeur ou le décodeur comprend un dispositif de ré-échantillonnage utilisant au moins deux filtres de ré-échantillonnage ayant des retards différents, un au moins des filtres étant mis en œuvre selon le procédé tel que décrit précédemment pour lequel la détermination du nombre d'échantillons de signal futur est fonction de la différence de retard des deux filtres de ré-échantillonnage utilisés.

Les filtres de ré-échantillonnage étant souvent associés à des modes de codage différents, ce mode de réali-

EP 3 053 163 B1

sation permet de commuter facilement d'un mode de codage à un autre sans qu'il n'y ait d'artefacts audibles.

L'invention vise un programme informatique comportant des instructions de code pour la mise en œuvre des étapes du procédé de ré-échantillonnage tel que décrit, lorsque ces instructions sont exécutées par un processeur.

Enfin l'invention se rapporte à un support de stockage, lisible par un processeur, intégré ou non au dispositif de ré-échantillonnage, éventuellement amovible, mémorisant un programme informatique mettant en œuvre un procédé de ré-échantillonnage tel que décrit précédemment.

D'autres caractéristiques et avantages de l'invention apparaîtront plus clairement à la lecture de la description suivante, et faite en référence aux dessins annexés, sur lesquels :

- la figure 1 illustre la réponse impulsionnelle d'un filtre de ré-échantillonnage dans une méthode de l'état de l'art telle que décrite précédemment;
- la figure 2 illustre la réponse impulsionnelle d'un filtre de ré-échantillonnage dans une méthode de l'état de l'art avec compensation du retard par des zéros telle que décrite précédemment;
- la figure 3 illustre un exemple de codeur de signal audio comportant un dispositif de ré-échantillonnage selon un mode de réalisation de l'invention;
- la figure 4a illustre sous forme d'organigramme, les étapes d'un procédé de ré-échantillonnage selon un mode de réalisation de l'invention;
- la figure 4b illustre sous forme d'organigramme, les étapes d'une variante de réalisation d'un procédé de ré-échantillonnage selon l'invention;
- la figure 5a illustre sous forme d'organigramme les détails de l'étape de détermination du facteur de préaccentuation (aussi dit pré-emphase) selon un mode de réalisation de l'invention;
- la figure 5b illustre sous forme d'organigramme les détails de l'étape de prédiction linéaire selon un mode de réalisation de l'invention;
- la figure 6 illustre la forme d'une fenêtre d'analyse utilisée dans un mode de réalisation de l'invention;
- les figures 7a à 7l montrent pour différentes positions d'échantillon postérieur à la trame courante de signal à ré-échantillonner, un comparatif du rapport signal à bruit en fonction de la fréquence centrale obtenu par l'application sur un signal de test de la méthode de ré-échantillonnage de l'état de l'art mise en œuvre dans le codeur AMR-WB et de la méthode de ré-échantillonnage selon un premier et un deuxième mode de réalisation de l'invention;
- les figures 8a à 8c montrent pour différentes positions d'échantillon postérieur à la trame courante de signal à ré-échantillonner, un comparatif du rapport signal à bruit pour 3 cas différents de changement de fréquences de ré-échantillonnage selon la méthode de ré-échantillonnage de l'état de l'art mise en œuvre dans le codeur AMR-WB et de la méthode de ré-échantillonnage selon un premier et un deuxième mode de réalisation de l'invention; et
- la figure 9 illustre un exemple de décodeur de signal audio comportant un dispositif de ré-échantillonnage selon un mode de réalisation de l'invention;
- la figure 10 illustre une représentation matérielle d'un dispositif de ré-échantillonnage selon un mode de réalisation de l'invention.

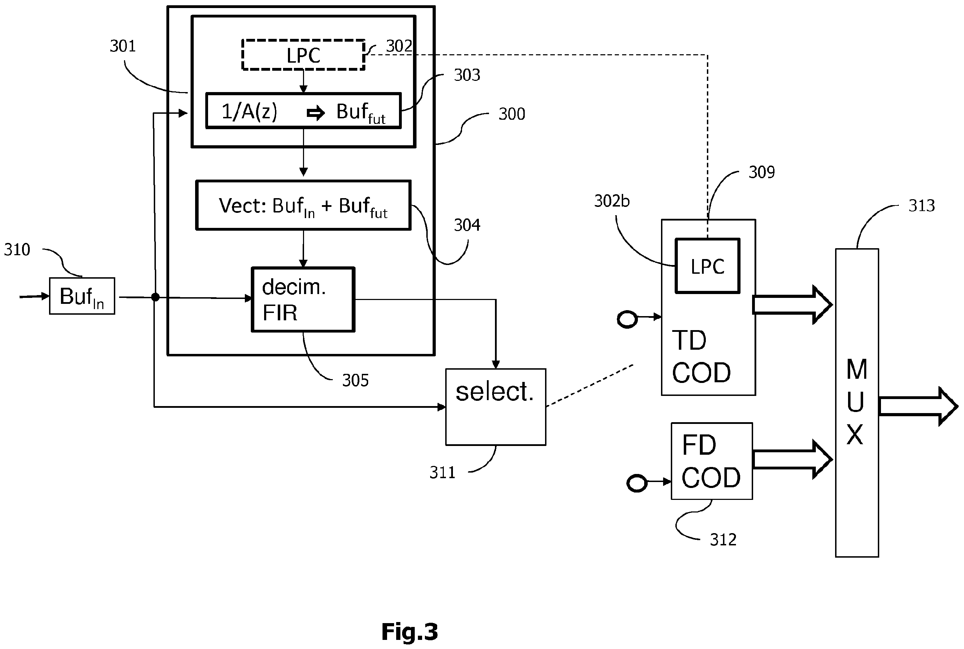

La **figure 3** illustre un exemple de codeur audio comportant un dispositif de ré-échantillonnage 300 selon un mode de réalisation de l'invention.

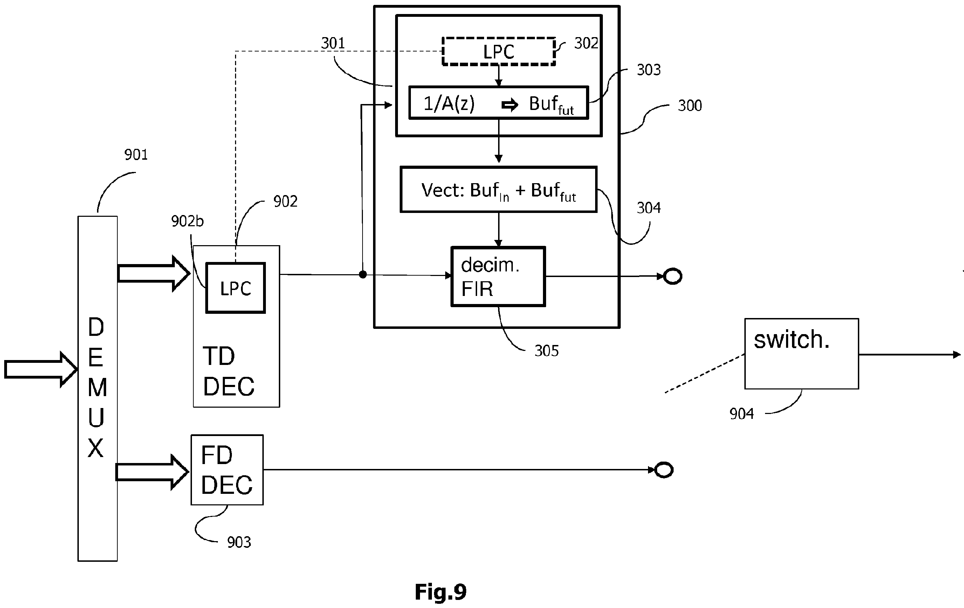

Le codec illustré ici est un codeur de signaux audio (mono), multi-débits (avec des débits fixes de 7.2 à 128 kbit/s) fonctionnant aux fréquences d'échantillonnage d'entrée et de sortie de 8, 16, 32 ou 48 kHz. On s'intéresse d'abord à la partie codeur représentée à la figure 3, le décodeur associé étant décrit plus loin en lien avec la figure 9.

Le signal d'entrée est divisé en trames de 20 ms (bloc 310), chaque trame peut être codée soit selon une approche temporelle (TD pour "Time Domain" en anglais) de type CELP (309) soit selon une approche fréquentielle (FD pour "Frequency Domain" en anglais) de type MDCT (bloc 312) avant d'être multiplexé par le module de multiplexage 313. On considère ici que les codages de type CELP et MDCT sont connus de l'homme de l'art. Le choix du mode (bloc 311) - qui inclut celui de la fréquence interne de codage - n'est pas détaillé ici.

Dans ce codec flexible en termes de débits et de fréquences d'échantillonnage, plusieurs configurations de ré-échantillonnage d'une fréquence 'f$_{In}$' (In pour input) à une fréquence 'f$_{Out}$' (Out pour output) sont nécessaires. Dans un mode de réalisation décrit ici, les configurations utilisées sont listées dans le tableau 1 ci-dessous :

**Tableau 1**

| Numéro de Config. | Configuration de conversion (f$_{In}$-> f$_{Out}$) | Filtre FIR utilisé | filt_len$_{in}$ | fac_num | fac_den |
|---|---|---|---|---|---|
| 1 | **8000 Hz** -> 12800 Hz | f_5_8_129 | 16 | 8 | 5 |
| 2 | 12800 Hz -> **8000 Hz** | f_5_8_129 | 24 | 5 | 8 |
| 3 | 16000 Hz -> **8000 Hz** | f_12_180 | 30 | 6 | 12 |

6

(suite)

| Numéro de Config. | Configuration de conversion ($f_{In}$-> $f_{Out}$) | Filtre FIR utilisé | filt_len$_{in}$ | fac_num | fac_den |
|---|---|---|---|---|---|
| 4 | 12800 Hz -> **16000 Hz** | f_15_180 | 12 | 15 | 12 |
| 5 | 12800 Hz -> **32000 Hz** | f_15_180 | 12 | 15 | 6 |
| 6 | 12800 Hz -> **48000 Hz** | f_15_180 | 12 | 15 | 4 |
| 7 | **16000 Hz** -> 12800 Hz | f_15_180 | 15 | 12 | 15 |
| 8 | 16000 Hz -> **32000 Hz** | f_12_180 | 15 | 12 | 6 |
| 9 | 16000 Hz -> **48000 Hz** | f_12_180 | 15 | 12 | 4 |
| 10 | **32000 Hz** -> 12800 Hz | f_15_180 | 30 | 6 | 15 |
| 11 | **32000 Hz** -> 16000 Hz | f_12_180 | 30 | 6 | 12 |
| 12 | **48000 Hz** -> 12800 Hz | f_15_180 | 45 | 4 | 15 |
| 13 | **48000 Hz** -> 16000 Hz | f_12_180 | 45 | 4 | 12 |

Dans ce tableau, les valeurs de fréquences en gras indiquent des fréquences « externes » (c'est-à-dire d'entrée et/ou de sortie) du codec, et les autres valeurs de fréquences sont des fréquences d'échantillonnage « internes » pour le codage de la bande basse du signal - d'une façon similaire au codage AMR-WB qui ne dispose que d'une fréquence externe à 16 kHz et d'une fréquence interne à 12.8 kHz. "filt_len$_{in}$" représente la longueur du filtre, "fac_num" représente le facteur de sur-échantillonnage et "fac_den" le facteur de sous-échantillonnage.

Sans perte de généralité, les filtres FIR sont conçus dans l'exemple illustré ici selon la méthode classique dite « méthode de la fenêtre », car il s'agit du fenêtrage d'un sinus cardinal (sin(x)/x). Les filtres FIR sont par exemple conçus comme expliqué ci-dessous.

Par exemple, le filtre f_5_8_129 est obtenu avec la commande matlab suivante:

$$f\_5\_8\_129 = [0\ 0\ 0\ 0\ fir1(248,(3775/32000),hanning(249))*4.999895\ 0\ 0\ 0\ 0];$$

avec une fréquence de coupure (-6 dB) à 64 kHz de 3775 Hz.

Ces coefficients sont utilisés comme un filtre de 16 coefficients à 8000 Hz (soit 128 coefficient à 64000Hz) et comme un filtre de 24 coefficient à 12800 Hz(soit 120 coefficients à 64000 Hz, en ignorant les dernières valeurs)

Le filtre f_12_180 est obtenu avec les commandes matlab suivantes:

$$ftmp = fir1(358,1/12,hanning(359));$$

$$f\_12\_180 = [0\ ftmp/ftmp(180)\ 0];$$

avec une fréquence de coupure (- 6 dB) à 192 kHz de 8000 Hz.

Le filtre f_15_180 est obtenu avec les commandes matlab suivantes:

$$ftmp = fir1(358,1/15,hanning(359));$$

$$f\_12\_180 = [0\ ftmp/ftmp(180)\ 0];$$

avec une fréquence de coupure (- 6 dB) à 192 kHz de 6400 Hz.

Dans des variantes de l'invention bien sûr on peut utiliser d'autres méthodes de conception de filtre FIR.

Ces configurations de conversion sont justifiées ici, sans perte de généralité, par l'utilisation de 2 fréquences internes, 12.8 kHz et 16 kHz, dans l'algorithme de codage. On ne détaille pas ici la façon dont le choix de la fréquence d'échantillonnage interne (12.8 ou 16 kHz) ni le choix du type de codage à employer (bloc 311) est effectué. Ceci dépasse le cadre de l'invention. Cependant, on retiendra que le choix de la fréquence interne peut se faire indépendamment dans chaque trame, pour une même fréquence d'entrée et / ou de sortie du codec, ce qui par exemple signifie qu'à la trame N on peut utiliser un ré-échantillonnage selon une configuration i, à la trame N+1 un ré-échantillonnage selon la configuration j différente de i (mais avec une même fréquence « externe »), et à la trame N+2 aucun ré-échantillonnage ce qui implique un codage direct de la trame à la fréquence d'entrée $f_{In}$ - en pratique ce dernier cas n'est possible dans le mode de réalisation privilégié que dans les situations suivantes :

- si le mode de codage choisi est le codage de type FD, lequel fonctionne toujours à la fréquence $f_{In}$
- si le mode de codage choisi est le codage TD et la fréquence d'entrée $f_{In}$ correspond à la fréquence interne de codage TD.

Cependant, dans une variante de l'invention, le codage de type FD pourra être contraint à fonctionner à la même fréquence interne de codage que le codage TD, afin d'en faciliter la commutation.

A noter que la transition d'un codage TD vers un codage FD et vice versa n'est pas décrite ici car elle dépasse le cadre de l'invention.

Quand la fréquence d'échantillonnage du signal d'entrée $f_{In}$ est supérieure à la fréquence d'échantillonnage interne de codage, l'algorithme de codage TD COD ou FC COD prévoit le codage du signal en bande haute (fréquences supérieures à 6.4 ou 7 kHz), ce codage de la bande haute n'est pas détaillé ici.

Ainsi le codeur comporte un dispositif de ré-échantillonnage 300 qui comporte un filtre de ré-échantillonnage paramétrable car il peut fonctionner avec plusieurs configurations de coefficients de filtre FIR (bloc 305). Dans les modes de réalisation décrits ci-après, le filtre de ré-échantillonnage est un filtre polyphase. L'invention s'applique également pour d'autres types de mise en œuvre de ré-échantillonnage par filtre FIR comme par exemple un filtre de ré-échantillonnage de complexité non-optimale qui ne fait pas intervenir la représentation en polyphase. Par ailleurs, l'invention s'applique aussi pour d'autres ratios de conversion de fréquence d'échantillonnage.

A l'exception des 3 premières configurations (de numéro 1 à 3), toutes les autres configurations utilisent un filtre polyphase de type FIR avec un retard de 0.9375 ms (12 échantillons à 12.8 kHz, 15 échantillons à 16 kHz, 30 échantillons à 32 kHz et 45 échantillons à 48 kHz).

Le filtrage polyphase de ré-échantillonnage (bloc 305) dans les configurations 4 à 13 s'effectue selon un algorithme dérivé du ré-échantillonnage polyphase par FIR défini dans le codec UIT-T G.718 (voir la réalisation dans le code source de G.718 dans le fichier "modify_fs.c").

On s'intéresse ici aux 3 premières configurations impliquant une fréquence d'échantillonnage « externe » de 8000 Hz. Pour ces configurations, un filtre FIR plus long est nécessaire pour avoir une performance de filtrage suffisante, en particulier pour garantir une réjection suffisante d'images spectrales ou du repliement spectral qui peuvent survenir dans les fréquences où l'oreille est très sensible.

Sans la mise en œuvre du procédé de ré-échantillonnage de l'invention, ces 3 configurations occasionneraient normalement 25 échantillons de retard à 12.8 kHz pour le cas du ré-échantillonnage de 8000 Hz à 12800 Hz, 15 échantillons de retard à 8 kHz pour les cas du ré-échantillonnage de 12800 Hz à 8000 Hz et du ré-échantillonnage de 16000 Hz à 8000 Hz. En général, le retard à la fréquence d'échantillonnage de sortie est l'arrondi à l'entier inférieur de filt_len*fac_num/fac_den, où filt_en est la longueur du filtre, fac_num est le facteur de sur-échantillonnage et fac_den est le facteur de sous-échantillonnage (voir aussi dans le tableau 1), mais il serait également possible de considérer un retard avec une fraction de ½ d'échantillon.

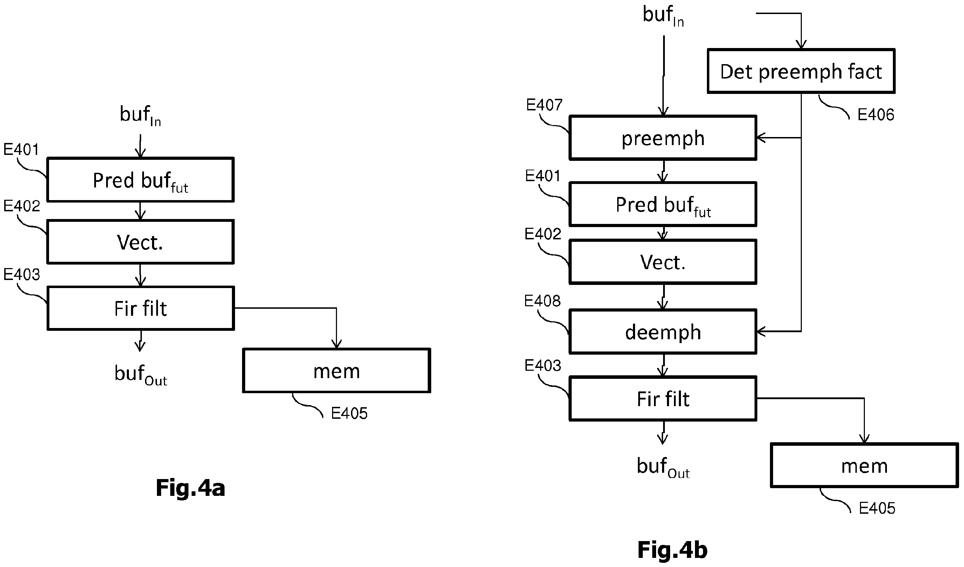

La mise en œuvre, dans le dispositif de ré-échantillonnage 300, du procédé de ré-échantillonnage selon l'invention et décrit ultérieurement en référence aux figures 4a et 4b, permet dans le cas de ce codeur :

- De limiter le retard effectif des configurations 1 à 3 pour obtenir un retard identique aux autres configurations 4 à 13 de conversion (lesquelles ont un retard de 0.9375 ms). Pour ce faire, le dispositif de ré-échantillonnage comporte un module 301 de prédiction linéaire adaptative, apte à déterminer, par trame de signal, un nombre d'échantillons de signal futur défini en fonction d'un retard de ré-échantillonnage choisi. On remarquera que le nombre d'échantillons est en théorie paramétrable mais en pratique il est gardé constant pour la configuration du codec définie.
- De pouvoir commuter toutes les configurations définies de ré-échantillonnage, même si le retard théorique associé est différent.

Dans un mode de réalisation particulier de l'invention qui n'est pas décrit au tableau 1, le codeur peut comporter plusieurs (au moins deux) filtres polyphases FIR de ré-échantillonnage occasionnant des retards différents. Par exemple dans un codeur multi-débit, pour une entrée qui est toujours à 16000 Hz, on peut utiliser 2 cœurs de codage à fréquence interne différente en fonction du débit : 8000 Hz pour les plus bas débits et 12800 Hz pour les plus hauts débits. Pour avoir une performance de filtrage suffisante, en particulier pour garantir une réjection suffisante d'images spectrales ou du repliement spectral, le ré-échantillonnage de 16000 Hz à 8000 Hz nécessite un filtre FIR plus long que le ré-échantillonnage de 16000 Hz à 12800 Hz. Ces deux filtrages ont donc un retard différent. Pour pouvoir commuter entre ces deux modes de codage sans artéfact (en cas de changement de débit) il faut harmoniser ces retards (les rendre égaux). Si on réduit la longueur du filtre FIR de ré-échantillonnage de 16000 Hz à 8000 Hz on dégrade en général la qualité car le repliement spectral ne serait pas suffisamment bien atténué et deviendrait audible. Si on augmente la longueur du filtre FIR de ré-échantillonnage de 16000 Hz à 12800 Hz ou on applique un retard supplémentaire sur le signal ré-échantillonné, on augmente le retard global du codage/décodage qui peut gêner l'interactivité.

En utilisant le procédé de ré-échantillonnage de la présente invention on peut réduire le retard des filtrages FIR plus longs jusqu'au niveau du retard du filtrage le plus court, sans perte notable de la qualité, en comparant avec le filtrage d'origine. En fait les résultats de simulation montrent que les rapports signal à bruit sont très hauts entre le filtrage normal et le filtrage à bas retard selon la présente invention. Il est également démontré par les tests d'écoute que la différence entre les signaux obtenus avec le filtrage normal et le filtrage à bas retard selon la présente invention n'est pas audible.

Ainsi, dans le cas présenté ici, le codeur (ou même le décodeur) comprend deux filtres polyphases de ré-échantillonnage dont les retards sont différents. Un au moins des filtres de ré-échantillonnage est un filtre mis en œuvre tel que décrit précédemment selon l'invention dans lequel la détermination du nombre d'échantillons de signal futur est fonction de la différence de retard des deux filtres de ré-échantillonnage utilisés dans les deux dispositifs.

Par exemple au tableau 1 les configurations 3 et 7 peuvent être utilisées pour une fréquence externe de 16000 Hz et des fréquences internes de 8000 Hz et 12800 Hz. Dans ce cas on voit que le retard à la fréquence d'entrée (filt_len) est respectivement de 30 et 15 échantillons ; Il faut donc prédire la différence, soit 15 échantillons à 16000 Hz pour pouvoir réduire le retard de la configuration 3 au niveau du retard de la configuration 7. L'invention détaillée plus loin pourra être utilisée pour diminuer le retard de la configuration 3 et pouvoir alterner entre les configurations 3 et 7 de façon transparente car elles ont alors le même retard de 15 échantillons.

Si l'on revient à l'exemple du codeur de la figure 3 et des configurations listées au tableau 1 :

Dans le cas du ré-échantillonnage de 8000 Hz à 12800 Hz, il faut réduire le retard de 25 à 12 échantillons, soit générer *plus_sample_out*=13 échantillons de plus à 12800 Hz, ce qui nécessite l'extrapolation de *plus_sample_in*=8 échantillons à 8000 Hz.

Pour le cas du ré-échantillonnage de 12800 Hz à 8000 Hz, il faut réduire le retard de 15 à 7 échantillons, soit générer *plus_sample_out*=8 échantillons de plus à 8000 Hz, ce qui nécessite l'extrapolation de *plus_sample_in*=12 échantillons à 12800 Hz.

Pour le cas du ré-échantillonnage de 16000 Hz à 8000 Hz, il faut réduire le retard de 15 à 7 échantillons, soit générer *plus_sample_out*=8 échantillons de plus à 8000 Hz, ce qui nécessite l'extrapolation de *plus_sample_in*=15 échantillons à 16000 Hz. A noter qu'à 8000 Hz 0.9375ms correspond à 7.5 échantillons qu'on a arrondi vers le bas à 7 échantillons.

Le dispositif de ré-échantillonnage 300 illustré à la figure 3, reçoit en entrée des blocs de signal audio, dans ce mode de réalisation ce sont des trames de 20ms reçus par le bloc 310 qui possède également en mémoire un ensemble d'échantillons de trames passés.

Ce dispositif de ré-échantillonnage comporte un module 301 de prédiction linéaire adaptative apte à déterminer par bloc ou trame de signal, un nombre d'échantillons de signal futur défini en fonction d'un retard de ré-échantillonnage choisi.

Ce nombre d'échantillons de signal futur prédit sert à déterminer le support de ré-échantillonnage défini par le module 304 de construction du vecteur support de ré-échantillonnage. Ce vecteur de support de ré-échantillonnage est par exemple, une concaténation d'échantillons éventuels de signal passé, des échantillons du bloc ou de la trame courante et des échantillons prédits de signal futur par le module 301. Les échantillons de signal passé servent comme mémoire du filtre FIR de ré-échantillonnage.

Néanmoins la construction de ce vecteur support comprend également la mise en œuvre suivante :

- Le signal passé peut être stocké dans les mémoires du filtre FIR de ré-échantillonnage et n'est donc pas directement concaténé aux échantillons de la trame courante (mais le signal de la trame courante est bien la continuité de ces mémoires contenant le signal passé)
- Le signal futur prédit peut être également stocké dans un vecteur séparé et son ré-échantillonnage peut être faire séparément de celui du signal de la trame courante, tant que les mémoires nécessaires sont mises à jour correctement. Dans le cas de ré-échantillonnage séparé du signal futur, on initialise les mémoires du filtre de ré-échantillonnage par les derniers échantillons de la trame courante. De nouveau, malgré cette séparation le signal futur prédit est bien la continuation du signal de la trame courante.

Dans ce document, sans perte de généralité, le terme « construction du vecteur de support » couvrent également les cas où les signaux ne sont pas réellement copiés les uns après les autres dans un même vecteur mais stockés dans différents vecteurs.

Le filtre 305 est alors appliqué à ce vecteur support de ré-échantillonnage pour obtenir un signal ré-échantillonné à la fréquence de sortie voulue.

Le module 301 de prédiction linéaire peut comporter un module 302 d'analyse de prédiction à court terme (LPC) apte à déterminer les coefficients d'un filtre de prédiction linéaire comme décrit ultérieurement en relation avec la figure 4a. Ce module d'analyse LPC (302b) peut dans un autre mode de réalisation avantageux être compris dans le module de codage par prédiction 309 du codage temporel de type TD (par exemple un codage CELP). Ainsi, un même module d'analyse peut être utilisé à la fois pour prédire des échantillons futurs utiles pour le dispositif de ré-échantillonnage et pour coder le signal avant transmission. Ceci diminue donc la complexité du dispositif de ré-échantillonnage qui coopère avec le module d'analyse du module de codage.

Le module 301 comporte en outre un module de filtrage 303 de prédiction par le filtrage 1/A(z) d'un signal nul pour obtenir un ensemble d'échantillons futurs $buf_{fut}$.

La **figure 4a** illustre donc les étapes principales d'un procédé de ré-échantillonnage selon un mode de réalisation de l'invention.

Les étapes de ce procédé sont mises en œuvre avec en entrée ($Buf_{In}$) des trames de *lg* échantillons à la fréquence échantillonnage d'entrée $f_{In}$. On accède également aux échantillons passés de ce signal d'entrée à travers les mémoires. A partir de ce signal d'entrée, l'étape E401 détermine le nombre d'échantillons à prédire *plus_sample_in,* en fonction du retard souhaité et prédit ce nombre d'échantillons du signal futur par prédiction linéaire. Le résultat de cette prédiction est concaténé au signal d'entrée (trame courante et trames passée pour les mémoires) à l'étape E402 de construction du vecteur support de ré-échantillonnage. Ce vecteur support est donc, dans un mode de réalisation, une concaténation d'échantillons du signal passé, des échantillons de la trame courante et des échantillons déterminés de signal futur.

A l'étape E403, on effectue le filtrage de ré-échantillonnage par application d'un filtre de ré-échantillonnage, par exemple à réponse impulsionnelle finie (FIR), sur les échantillons du vecteur support de ré-échantillonnage, et le signal ré-échantillonné $buf_{out}$ est fourni en sortie, à la fréquence de ré-échantillonage de sortie $f_{out}$.

Plusieurs cas sont alors possibles :

- Dans le cas d'une utilisation trame par trame continue (*lg* échantillons en entrée), seuls les derniers *lg_out = lg\*fac_num/fac_den* échantillons sont calculés.

- Dans le cas où plus d'échantillons doivent être obtenus (utilisation par trame avec signal futur) (*lg+ plus_sample_in* échantillons en entrée), comme c'est le cas dans le codeur de la norme AMR-WB, *lg_out+plus_sample_out* échantillons sont calculés, où *plus_sample_out=plus_sample_in\*fac_num/fac_den.* En fait dans le codeur AMR-WB, on ré-échantillonne la trame courante de 20 ms et on ré-échantillonne en plus 15 échantillons ; la première étape remplace l'erreur de ré-échantillonnage effectuée lors de la seconde étape. Dans cet exemple, *lg=320, plus_sample_in=15.*

- L'utilisation peut être également ponctuelle quand on ré-échantillonne par exemple une mémoire (un morceau ou bloc du signal) par exemple dans le cas d'une commutation entre deux modes de codage. Dans ce cas l'entrée du ré-échantillonnage n'est pas une trame (par exemple de 20 ms) mais un bloc de signal. Afin d'appliquer l'invention, il est important de remarquer qu'il faut disposer ou bien du passé du bloc à convertir ou bien d'un modèle LPC déjà pré-calculé du passé - on remarquera qu'avec un codage de type TD utilisant déjà une prédiction linéaire, il est en général possible de mémoriser les paramètres (coefficients LPC ou équivalents) calculés et/ou codés dans le codeur et/ou décodeur TD dans chaque trame. Ainsi dans une variante de l'invention ces paramètres LPC pourront être réutilisés, ce qui simplifie la mise en œuvre du bloc 302 puisqu'il s'agit alors d'une simple consultation de valeurs mémorisées (éventuellement quantifiées).

En parallèle on met à jour la mémoire du filtre de ré-échantillonnage en E405. De nouveau, plusieurs cas sont possibles :

- Dans le cas d'une utilisation continue avec plus d'échantillons à générer, comme c'est le cas dans la norme AMR-WB, on mémorise les derniers *mem_len* échantillons de la trame d'entrée, sans les échantillons prédits: *mem_sig(0... mem_len-1) = frame(lg-mem_len ... lg-1).*
A la reprise du ré-échantillonnage, les échantillons obtenus à la fréquence d'échantillonnage de sortie remplacent les échantillons obtenus en utilisant le signal d'entrée prédit.

- En cas d'utilisation trame par trame continue on ne remplace pas les échantillons obtenus en utilisant le signal d'entrée prédit, on ne calcule que *lg_out* échantillons à la fréquence d'échantillonnage de sortie. Si on considère que la nouvelle trame commence à l'échantillon d'indice *lg+ plus_sample_in* , la mémoire du filtrage FIR de ré-échantillonnage est constitué des échantillons passés d'indice (*lg+ plus_sample_in-mem-len ... lg+ plus_sample_in-1*) dont une partie de cette mémoire, d'indice (*lg ... lg+ plus_sample_in-1*), peut être soit le vrai signal soit le signal prédit. En utilisant le vrai signal les premiers échantillons sont égaux avec ceux obtenus avec un filtrage sans prédiction (résultat considéré comme optimal) mais entre le dernier échantillon obtenu avec la prédiction durant la trame précédente et le premier échantillon obtenu avec le vrai signal on peut avoir une petite discontinuité. En cas d'utilisation du signal prédit dans la mémoire il n'y pas de discontinuité mais une légère erreur s'étale sur encore *filt_len* échantillons. Dans le mode de réalisation privilégié on utilise la première solution car cette légère discontinuité n'est pas audible.

- En cas d'utilisation ponctuelle la mise à jour de mémoire n'est pas nécessaire après le ré-échantillonnage, par contre il faut bien initialiser les mémoires de ré-échantillonnage avant l'opération de ré-échantillonnage, avec le signal d'entrée passé correspondant.

Dans une variante, l'analyse LPC servant à prédire le signal futur est réalisée non pas sur le signal direct dans la trame courante, mais sur le signal pré-accentué, issu du filtrage de la trame courante par un filtre de la forme 1-μ.$z^{-1}$, où μ est calculé de façon adaptative ou fixé à une valeur prédéterminée. Cette variante est illustrée sur la **figure 4b**. Par rapport à la figure 4a, une étape E406 de détermination du facteur de préaccentuation μ est ajoutée. En utilisant ce facteur μ le signal d'entrée est pré-accentué à l'étape E407 par filtrage 1-μ .$z^{-1}$. A noter que ce filtrage nécessite un échantillon de mémoire, donc dans cette variante la taille de la mémoire est à augmenter de 1. Le signal pré-accentué est l'entrée des étapes E401 et E402. Le signal concaténé est ensuite désaccentué en utilisant le même facteur μ à l'étape E408 par filtrage 1/(1- μ$z^{-1}$) . A noter que pour un signal donné, l'enchainement de la préaccentuation avant analyse LPC suivi par une désaccentuation de même facteur μ est transparent, c'est-à-dire qu'on retrouve exactement le signal d'entrée. Donc si on mémorise le signal avant la préaccentuation seule la partie prédite doit être désaccentuée pour réduire la complexité de calcul. Cette partie prédite désaccentuée est ensuite concaténée au signal mémorisé pour former le vecteur support de ré-échantillonnage.

Plusieurs techniques existent pour déterminer le facteur de préaccentuation μ dont les valeurs sont entre -1 et 1.

- μ peut être constant, par exemple μ=0.68
- μ peut être constant dépendant de la fréquence d'échantillonnage d'entrée
- μ peut être adaptatif en fonction d'une analyse du tilt du spectre (méthode connue de l'état de l'art).

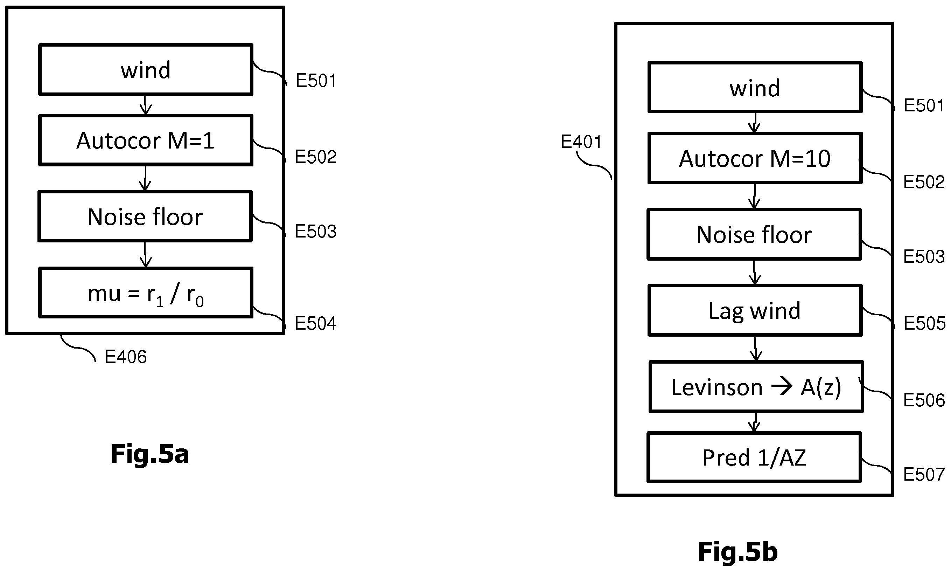

La **figure 5a** illustre cette étape E406 de la figure 4b, de détermination du facteur de préaccentuation. A l'étape E501, on fenêtre le signal par une fenêtre d'analyse. A l'étape E502, on calcule une autocorrélation d'ordre M=1 ( r(0) et r(1)) et on applique un seuil de bruit ("noise floor" en anglais) sur r(0) à l'étape E503, pour éviter les problèmes arithmétiques des signaux d'entrée de niveau faible.

Ces étapes d'autocorrélation, d'application d'un seuil de bruit sont par exemple décrit dans la recommandation ITU-T G.729 paragraphe 3.2.1.

Ces calculs d'autocorrélations r(k) avec une fenêtre de longueur *L*, pour les décalages k=0,...,M sont de la forme:

$$r(k) = \sum_{n=k}^{L-1} s_w(n) s_w(n-k), \qquad k = 0,...,M$$

où $s_w(n) = s(n).w(n)$ et $s(n)$ correspond aux derniers *L* échantillons du signal de la trame courante et éventuellement de signal passé si la longueur L est supérieure à la longueur de la trame courante.

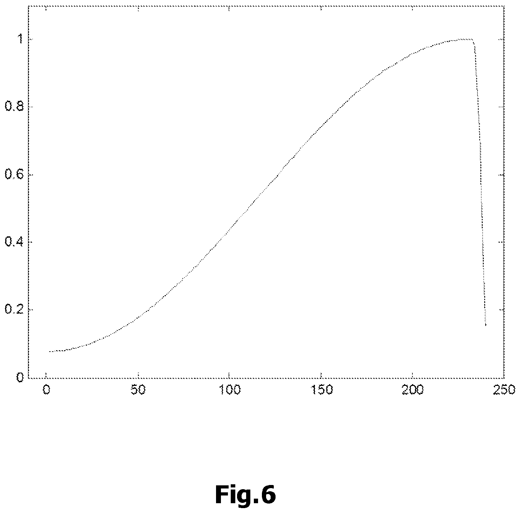

Dans le mode de réalisation privilégié, on utilise une fenêtre LPC w(n) de longueur L=240 dont un exemple est illustré à la **figure 6.**

On peut voir que la forme de cette fenêtre est asymétrique avec le poids concentré sur la fin de son support (sur les échantillons les plus récents). Les commandes Matlab pour construire cette fenêtre avec L = 240 sont par exemple données ci-dessous :

```
L1=L-8;
for i = 0 : (L1-1)
 w(i+1) = 0.54 - 0.46 * cos(2 * i * pi / (2 * L1 - 1));
end
for i = L1 : (L-1)
 w(i+1) = cos((i - L1) * 2 * pi / (31));
end
```

Dans des variantes de l'invention, d'autres valeurs de l'ordre LPC M, d'autres formes et longueurs de fenêtre LPC pourront être utilisées sans changer la nature de l'invention. Le « noise floor » pourra être utilisé de façon classique en multipliant le premier coefficient de corrélation par un facteur >1 ou en limitant la valeur de ce premier coefficient à une valeur minimale.

Finalement le facteur est calculé à l'étape E504 comme $\mu = r(1)/r(0)$.

La **figure 5b** décrit plus en détails, un mode de réalisation de l'étape E401 des figures 4, de prédiction linéaire pour déterminer les échantillons futurs selon l'invention.

Par exemple, cette étape E401 peut comporter une étape E506 de calcul de coefficients d'un filtre de prédiction linéaire d'ordre prédéterminé, à partir des échantillons de la trame courante et éventuellement des échantillons des trames précédentes et une étape E507 d'obtention des échantillons de signal futur par application du filtre de prédiction calculé à un signal d'excitation de valeur nulle.

Les étapes E501, E502 et E503 des figures 5a et 5b sont similaires, mais avec un ordre de prédiction M différent. Les autres paramètres comme la forme ou la longueur de la fenêtre d'analyse ou encore le « noise floor » peuvent être également différents. Dans les 2 cas on peut utiliser les modules communs pour réduire la complexité.

De façon plus précise, le signal d'entrée (pré-accentué ou non) est fenêtré à l'étape E501. On peut par exemple utiliser le même type de fenêtre que celle illustré sur la figure 6. On calcule la fonction d'autocorrélation à l'ordre choisi (dans l'exemple M=10) en E502 et on applique un seuil de bruit, "noise floor" sur r(0) à l'étape E503, comme décrit par exemple dans le paragraphe 3.2 de la norme G.729.

A l'étape E505, on effectue une étape appelée « lag windowing » en anglais (méthode connue par l'homme de l'art), aussi décrite notamment dans le paragraphe 3.2.1 de la norme G.729.

Cette étape de "Lag windowing" pour la fréquence d'échantillonnage d'entrée ($f_{In}$) est de la forme :

$$r(i) = r(i) * w_{lag}(i) \, , \, i=0,...,M$$

où les coefficients $w_{lag}(i)$ sont définis comme suit :

$$w_{lag}(i) = \exp\left[ -\frac{1}{2}\left( \frac{2\pi f_0 i}{f_s} \right)^2 \right], \qquad i = 1,...,16$$

où $f_s = f_{In}$ est la fréquence du signal à ré-échantillonner et où par exemple $f_0 = 60$ Hz.

A l'étape E506 (mis en œuvre par le module 302 de la figure 3) on calcule les coefficients A[i], i=0,...,M, d'un filtre de prédiction linéaire A(z) d'ordre M par l'algorithme de Levinson-Durbin comme décrit en référence au paragraphe 3.2.2 du G.729 ou au paragraphe 6.4.3 de la norme AMR-WB. Dans le mode de réalisation privilégié, on utilise un ordre LPC M=10.

A l'étape E 507 (mis en œuvre par le module 303 de la figure 3), le filtre de synthèse 1/A(z) est appliqué à un signal nul pour donner une prédiction des échantillons de signal futur.

On effectue cette prédiction de façon récursive, par filtrage 1/A(z) avec entrée (signal d'excitation du filtre) nulle, pour *plus_sample_in* échantillons à la fin de la trame de longueur *lg* (*i = lg ... lg+plus_sample_in -1*) :

$$\text{sig}(i) = \sum_{j=1}^{M} -sig(i-j) * a(j)$$

Dans une variante de l'invention, d'autres méthodes de calcul des coefficients de prédiction linéaire pourront être utilisées, par exemple on pourra utiliser la méthode de Burg mise en œuvre par exemple dans le codeur SILK connu de l'état de l'art.

Dans une autre variante, les coefficients de prédiction linéaire pourront être estimés par une approche de type LMS (Least Mean Squares) ou RLS (Recursive Least Squares) de filtrage adaptatif.

Dans une autre alternative, les coefficients LPC pourront être directement obtenus d'une analyse et/ou quantification des paramètres associés, effectuées sur le signal dans le codeur de type TD (309) utilisant une prédiction LPC (302b), voire dans le codeur FD, à condition d'effectuer une prédiction linéaire dans le codeur FD.

Par exemple, dans le décodeur CELP du codec AMR-WB on dispose des coefficients LPC (d'ordre 16) dans chaque sous-trame et on peut en particulier utiliser les coefficients LPC décodés dans la dernière sous-trame pour prédire le signal décodé futur et ainsi éliminer le retard du ré-échantillonnage du décodeur CELP.

Dans une autre variante, l'excitation nulle (entrée nulle) à l'étape E507 peut être remplacée par une excitation prédite, par exemple par prédiction de pitch dans le domaine de l'excitation.

Dans d'autres variantes de l'invention, la prédiction linéaire (à court-terme) sera remplacée par une prédiction de pitch (à long-terme) dans le domaine du signal, cette prédiction peut être fractionnaire ou multi-tap.

On notera qu'il serait possible d'effectuer la prédiction dans le domaine fréquentiel au lieu d'une approche temporelle ; cependant cette approche alternative dans le domaine fréquentiel nécessite une transformation d'analyse (par exemple FFT), une prédiction du spectre futur par exemple par répétition des amplitudes et continuité des phases des raies spectrales les plus importantes et une transformation inverse de synthèse ou une synthèse sinusoïdale ; cette alternative est en général plus complexe que l'approche temporelle décrite précédemment, d'autant plus que l'analyse fréquentielle doit avoir un support temporel suffisamment long pour disposer d'une résolution fréquentielle suffisante pour identifier des raies spectrales (tones). Cette approche n'est pas idéale lorsqu'il s'agit d'extrapoler un nombre limité d'échantillons (inférieur à la longueur de trame).

Dans encore un autre mode de réalisation, la prédiction linéaire adaptative décrite précédemment peut être remplacée par un processus de dissimulation de trame effacée afin d'extrapoler le signal futur par un modèle de signal plus évolué. Une telle technique est par exemple décrite dans le brevet européen publié sous le numéro: EP1 316 087.

Dans d'autres variantes d'invention le ré-échantillonnage par filtre FIR pourra être remplacé par d'autres méthodes de ré-échantillonnage par filtrage IIR ou l'interpolation polynomiale. Dans ce cas le principe reste le même : on prédit le signal futur et on applique le ré-échantillonnage en prenant en compte le signal futur. Dans un mode de réalisation on considère le cas de 2 configurations de ré-échantillonnage de retards différents et l'invention permet de ramener le retard le plus long à la valeur du retard le plus faible.

Pour pouvoir bien démontrer l'efficacité de ré-échantillonnage à bas retard selon le procédé de l'invention décrit précédemment dans l'exemple de ré-échantillonnage de 8000 Hz à 12800Hz, on utilise un signal de test constitué d'un mélange de 10 sinusoïdes dont la fréquence change à chaque seconde. Pour le signal de $i^{ème}$ seconde les fréquences de ces sinusoïdes ont été choisies de façon aléatoire, autour d'une fréquence centrale $fe_{centre}(i)$, dans l'intervalle $[fe_{centre}(i)-600, fe_{centre}(i)+600]$ et $fe_{centre}(i) = 500+100*i$ Hz, $i = 1 \ldots 28$.

Les **figures 7a à 7l** représentent les résultats d'une comparaison entre la méthode de ré-échantillonnage de l'état de l'art dans AMR-WB (en pointillé), celle du procédé selon l'invention avec un filtre de prédiction d'ordre M=4 avec fenêtre d'analyse de 20 échantillons (en trait discontinue) et celle du procédé selon l'invention avec un filtre de prédiction linéaire d'ordre 10 avec fenêtre d'analyse de 240 échantillons (trait continu).

Les figures représentent le rapport signal sur bruit en fonction de la fréquence centrale du signal de test.

Chaque figure correspond à une position différente de l'échantillon par rapport à la fin de la trame classique obtenu avec un filtrage classique (qui correspond à la numérotation #1, ..., #12 de la figure 2). Par exemple, la figure 7a représente le rapport signal à bruit (RSB, SNR en anglais) pour les échantillons en $2^{ème}$ position après la fin de la trame classique. La figure 7b représente le rapport signal à bruit pour l'échantillon prédit en $3^{ième}$ position après la trame courante, etc... La figure 7l représente donc le rapport signal à bruit pour l'échantillon prédit en $13^{ième}$ position après la trame courante.

On peut observer que le RSB diminue avec l'augmentation de la position car on utilise de plus en plus d'échantillons prédits lors du filtrage et que pour la même position, le RSB diminue avec l'augmentation de la fréquence centrale car les hautes fréquences sont moins prédictibles. Cependant, dans tous les cas, on observe que la méthode selon l'invention, même à faible ordre de prédiction, est nettement plus performante que la méthode utilisée dans le codeur AMR-WB.

L'avantage de l'utilisation d'une prédiction d'ordre faible est sa faible complexité et la facilité de mise en œuvre des calculs, surtout en arithmétique en virgule fixe. Plus l'ordre est élevé, plus la complexité augmente et en même temps plus il devient difficile d'assurer la stabilité du filtre.

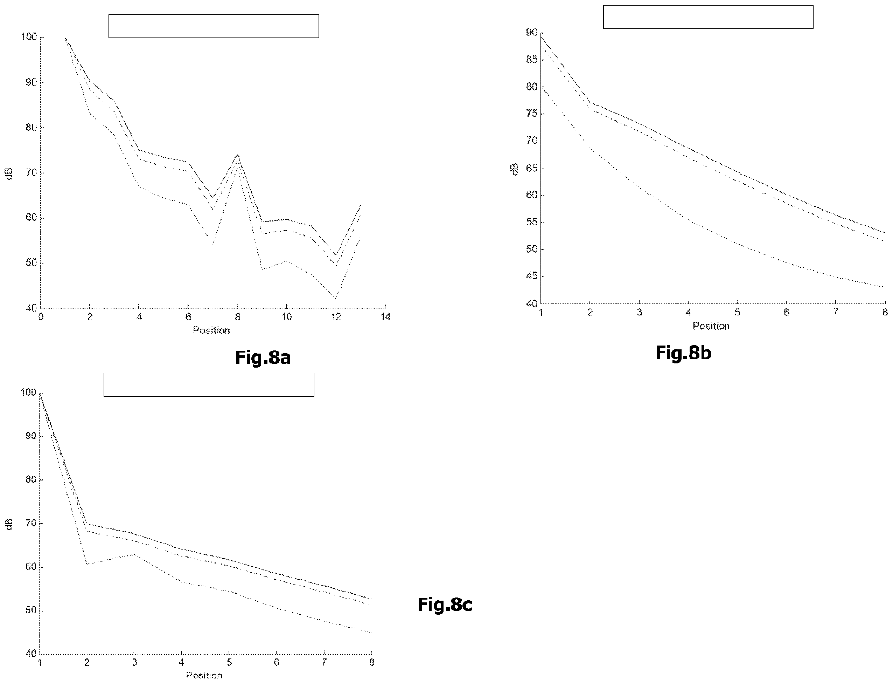

Les **figures 8a à 8c** montrent le même type de résultat sur une très grande base de signal de parole. On y voit le RSB en fonction de la position de l'échantillon pour 3 cas différent : de 8000Hz à 12800 Hz en figure 8a, de 12800 Hz à 8000 Hz en figure 8b et de 16000 Hz à 8000 Hz en figure 8c. De nouveau, l'algorithme selon l'invention est nettement plus performant que celui utilisé dans l'état de l'art (AMR-WB), même à faible ordre de prédiction avec fenêtre courte.

La **figure 9** illustre un exemple de décodeur audio comportant un dispositif de ré-échantillonnage 300 selon l'invention. Le dispositif de ré-échantillonnage est le même que celui décrit en référence à la figure 3.

Le décodeur illustré ici est un décodeur de signaux audio (mono), multi-débits (avec des débits fixes de 7.2 à 128 kbit/s) fonctionnant aux fréquences d'échantillonnage de sortie de 8, 16, 32 ou 48 kHz.

En fonction de la trame reçue et dé-multiplexée (bloc 901), la sortie est commutée (904) entre la sortie d'un décodeur temporel (TD DEC) de type CELP (902) utilisant une prédiction linéaire (902b) et un décodeur fréquentiel (FD DEC).

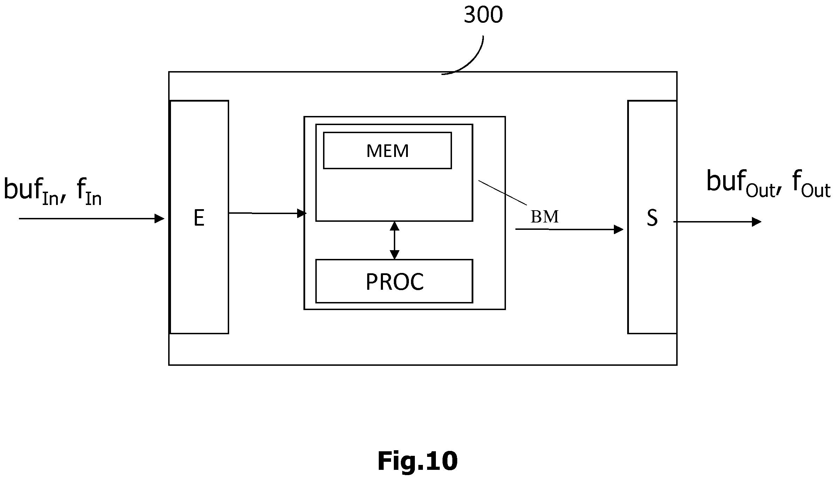

La **figure 10** représente un exemple de réalisation matérielle d'un dispositif de ré-échantillonnage 300 selon l'invention. Celui-ci peut faire partie intégrante d'un codeur, décodeur de signal audiofréquence ou d'un équipement recevant des signaux audiofréquences.

Ce type de dispositif comporte un processeur PROC coopérant avec un bloc mémoire BM comportant une mémoire de stockage et/ou de travail MEM.

Un tel dispositif comporte un module d'entrée E apte à recevoir des trames de signal audio $Buf_{In}$ à une fréquence d'échantillonnage $f_{In}$ .

Il comporte un module de sortie S apte à transmettre le signal audio fréquence ré-échantillonné $Buf_{Out}$ à la fréquence d'échantillonnage de $f_{Out}$.

Le bloc mémoire peut avantageusement comporter un programme informatique comportant des instructions de code pour la mise en œuvre des étapes du procédé de ré-échantillonnage au sens de l'invention, lorsque ces instructions sont exécutées par le processeur PROC, et notamment les étapes de détermination par prédiction linéaire adaptative d'un nombre d'échantillons de signal futur, ce nombre étant défini en fonction d'un retard de ré-échantillonnage choisi, de construction d'un vecteur support de ré-échantillonnage à partir au moins des échantillons du bloc courant et des échantillons déterminés de signal futur, d'application d'un filtre de ré-échantillonnage sur les échantillons du vecteur support de ré-échantillonnage.

Typiquement, la description de la figure 4a reprend les étapes d'un algorithme d'un tel programme informatique. Le programme informatique peut également être stocké sur un support mémoire lisible par un lecteur du dispositif ou téléchargeable dans l'espace mémoire de celui-ci.

La mémoire MEM enregistre de manière générale, toutes les données nécessaires à la mise en œuvre du procédé.

**Revendications**

1. Procédé de ré-échantillonnage d'un signal audiofréquence dans un codage ou décodage de signal audiofréquence, **caractérisé en ce qu'**il comporte les étapes suivantes par bloc de signal à ré-échantillonner:

   - détermination (E401) par prédiction linéaire adaptative d'un nombre d'échantillons de signal futur, ce nombre étant défini en fonction d'un retard de ré-échantillonnage choisi ;
   - construction (E402) d'un vecteur support de ré-échantillonnage à partir au moins des échantillons du bloc courant de signal et des échantillons déterminés de signal futur;
   - application (E403) d'un filtre de ré-échantillonnage sur les échantillons du vecteur support de ré-échantillonnage.

2. Procédé selon la revendication 1, **caractérisé en ce que** l'étape de détermination par prédiction linéaire adaptative comprend les étapes suivantes:

   - obtention (E506) de coefficients d'un filtre de prédiction linéaire d'ordre prédéterminé;
   - obtention (E507) des échantillons de signal futur par application du filtre de prédiction obtenu à un signal d'excitation de valeur nulle.

3. Procédé selon la revendication 2, **caractérisé en ce que** les coefficients du filtre de prédiction linéaire sont obtenus par lecture de paramètres mémorisés à l'étape de codage ou de décodage.

4. Procédé selon la revendication 2, **caractérisé en ce que** les coefficients du filtre de prédiction linéaire sont obtenus par analyse à partir au moins des échantillons du bloc courant.

5. Procédé selon la revendication 1, **caractérisé en ce que** la prédiction linéaire est effectuée sur un signal audiofréquence sur lequel un traitement de préaccentuation a été effectué.

6. Procédé selon la revendication 1, **caractérisé en ce que** la prédiction linéaire adaptative est une prédiction parmi l'une des méthodes suivantes:

   - prédiction linéaire à court terme;
   - prédiction linéaire à long terme;
   - combinaison de prédiction linéaire à court terme et de prédiction linéaire à long terme;
   - processus de dissimulation de trame effacée.

7. Dispositif de ré-échantillonnage d'un signal audiofréquence dans un codeur ou décodeur de signal audiofréquence, **caractérisé en ce qu'**il comporte:

   - un module (301) de prédiction linéaire adaptative apte à déterminer pour un bloc de signal, un nombre d'échantillons de signal futur défini en fonction d'un retard de ré-échantillonnage choisi;
- un module (304) de construction d'un vecteur support de ré-échantillonnage à partir au moins des échantillons du bloc courant de signal et des échantillons déterminés de signal futur;
- un filtre (305) de ré-échantillonnage appliqué sur les échantillons du vecteur support de ré-échantillonnage.

8. Dispositif selon la revendication 7, **caractérisé en ce que** le module de prédiction linéaire adaptative coopère avec un module d'analyse (302b) par prédiction compris dans le module de codage ou de décodage par prédiction, du codeur ou décodeur.

9. Codeur de signal audiofréquence **caractérisé en ce qu'**il comporte au moins un dispositif de ré-échantillonnage selon l'une des revendications 7 ou 8.

10. Codeur selon la revendication 9, **caractérisé en ce qu'**il comprend un dispositif de ré-échantillonnage utilisant au moins deux filtres de ré-échantillonnage ayant des retards différents, un au moins des filtres étant mis en œuvre conformément au procédé de la revendication 1, dans lequel la détermination du nombre d'échantillons de signal futur est fonction de la différence de retard des deux filtres de ré-échantillonnage utilisés.

11. Décodeur de signal audiofréquence **caractérisé en ce qu'**il comporte au moins un dispositif de ré-échantillonnage selon l'une des revendications 7 ou 8.

12. Décodeur selon la revendication 11, **caractérisé en ce qu'**il comprend un dispositif de ré-échantillonnage utilisant au moins deux filtres de ré-échantillonnage ayant des retards différents, un au moins des filtres étant mis en œuvre conformément au procédé de la revendication 1, dans lequel la détermination du nombre d'échantillons de signal futur est fonction de la différence de retard des deux filtres de ré-échantillonnage utilisés.

13. Programme informatique comportant des instructions de code pour la mise en œuvre des étapes du procédé de ré-échantillonnage selon l'une des revendications 1 à 6, lorsque ces instructions sont exécutées par un processeur.

14. Support de stockage lisible par un processeur, sur lequel est stocké un programme informatique comprenant des instructions de code pour l'exécution des étapes du procédé de ré-échantillonnage selon l'une des revendications 1 à 6.

## Patentansprüche

1. Verfahren zum Resampling eines Tonfrequenzsignals in eine Tonfrequenzsignal-Codierung oder -Decodierung, **dadurch gekennzeichnet, dass** es die folgenden Schritte pro Signalblock umfasst, der dem Resampling unterzogen werden soll:

   - Bestimmung (E401), durch adaptive lineare Vorhersage, einer Anzahl zukünftiger Werte des Resampling des Signals, wobei diese Anzahl in Abhängigkeit vom Unterschied der Verzögerung der beiden verwendeten Resampling-Filter bestimmt ist.
   - Konstruktion (E402) eines Resampling-Unterstützungsvektors aus zumindest den Abtastwerten des aktuellen Signalblocks und bestimmten zukünftigen Signalabtastwerten;
   - Anwendung (E403) eines Resampling-Filters auf die Abtastwerten des Resampling-Unterstützungsvektors.

2. Verfahren nach Anspruch 1, **dadurch gekennzeichnet, dass** der Schritt des Bestimmens durch adaptive lineare Prädiktion die folgenden Schritte umfasst:

   - Erhalten (E506) von Koeffizienten eines linearen Prädiktionsfilters vorbestimmter Ordnung;
   - Erhalten (E507) zukünftiger Signalabtastwerte durch Anwenden des erhaltenen Prädiktionsfilters auf ein Erregungssignal mit Nullwert.

3. Verfahren nach Anspruch 2, **dadurch gekennzeichnet, dass** die Koeffizienten des linearen Prädiktionsfilters durch Lesen von Parametern erhalten werden, die in dem Codierungs- oder Decodierungsschritt gespeichert sind.

4. Verfahren nach Anspruch 2, **dadurch gekennzeichnet, dass** die Koeffizienten des linearen Prädiktionsfilters durch Analyse von zumindest den Abtastwerten des aktuellen Blocks erhalten werden.

5. Verfahren nach Anspruch 1, **dadurch gekennzeichnet, dass** die lineare Vorhersage an einem Audiofrequenzsignal durchgeführt wird, an dem eine Vorverzerrungsverarbeitung durchgeführt worden ist.

6. Verfahren nach Anspruch 1, **dadurch gekennzeichnet, dass** die adaptive lineare Vorhersage eine Vorhersage aus einem der folgenden Verfahren ist:

   - kurzfristige lineare Vorhersage;
   - langfristige lineare Vorhersage;
   - Kombination aus kurzfristiger linearer Vorhersage und langfristiger linearer Vorhersage;
   - Verfahren zum Ausblenden einer gelöschten Grundstruktur.

7. Vorrichtung zum Resampling eines Audiofrequenzsignals in einem Audiofrequenzsignal-Kodierer oder -Dekodierer, **dadurch gekennzeichnet, dass** sie umfasst:

   - ein adaptives lineares Vorhersagemodul (301), das in der Lage ist, für einen Signalblock eine Anzahl zukünftiger Signalabtastwerte zu bestimmen, die in Abhängigkeit von einer gewählten Verzögerung des Resampling definiert sind;
   - ein Modul (304) zum Konstruieren eines Resampling-Unterstützungsvektors aus zumindest Abtastwerten des aktuellen Signalblocks und bestimmten zukünftigen Signalabtastwerten;
   - einen Resampling-Filter (305), der auf die Abtastwerte des Resampling-Unterstützungsvektors angewendet wird.

8. Vorrichtung nach Anspruch 7, **dadurch gekennzeichnet, dass** das adaptive lineare Vorhersagemodul mit einem Analysemodul (302b) durch Vorhersage kooperiert, die in dem Codierungs- oder Decodierungsmodul durch Vorhersage des Codierers oder des Decoders enthalten ist.

9. Tonfrequenzsignal-Codierer, **dadurch gekennzeichnet, dass** er mindestens eine Resampling-Vorrichtung nach einem der Ansprüche 7 oder 8 umfasst.

10. Codierer nach Anspruch 9, **dadurch gekennzeichnet, dass** er eine Resampling-Vorrichtung umfasst, die mindestens zwei Resampling-Filter mit unterschiedlichen Verzögerungen verwendet, wobei mindestens einer der Filter gemäß dem Verfahren nach Anspruch 1 implementiert ist, bei dem die Anzahl zukünftiger Werte des Resampling des Signals abhängig vom Unterschied der Verzögerung der beiden verwendeten Resampling-Filter bestimmt ist.

11. Tonfrequenzsignal-Decoder, **dadurch gekennzeichnet, dass** er mindestens eine Resampling-Einrichtung nach einem der Ansprüche 7 oder 8 umfasst.

12. Decoder nach Anspruch 11, **dadurch gekennzeichnet, dass** er eine Resampling-Vorrichtung umfasst, die mindestens zwei Resampling-Filter mit unterschiedlichen Verzögerungen verwendet, wobei mindestens einer der Filter gemäß dem Verfahren nach Anspruch 1 implementiert ist, bei dem die Anzahl zukünftiger Werte des Resampling des Signals abhängig vom Unterschied der Verzögerung der beiden verwendeten Resampling-Filter bestimmt ist.

13. Computerprogramm, umfassend Codeanweisungen zum Implementieren der Schritte des Resampling-Verfahrens einem der Ansprüche 1 bis 6, wenn diese Anweisungen von einem Prozessor ausgeführt werden.

14. Von einem Prozessor lesbares Speichermedium, auf dem ein Computerprogramm gespeichert ist, das Codeanweisungen zur Ausführung der Schritte des Resampling-Verfahrens nach einem der Ansprüche 1 bis 6 umfasst.

**Claims**

1. A method for resampling an audio frequency signal in an audio frequency signal coding or decoding, **characterized in that** it comprises the following steps per block of signal to be resampled:

   - determining (E401) by adaptive linear prediction a number of future signal samples, this number being defined as a function of a chosen resampling delay;
   - constructing (E402) a resampling support vector from at least the samples of the current signal block and the determined samples of future signal;

- applying (E403) a resampling filter on the samples of the resampling support vector.

2. The method according to Claim 1, **characterized in that** the step of determining by adaptive linear prediction comprises the following steps:

- obtaining (E506) coefficients of a linear prediction filter of predetermined order;
- obtaining (E507) future signal samples by applying the prediction filter obtained to an excitation signal of zero value.

3. The method according to Claim 2, **characterized in that** the coefficients of the linear prediction filter are obtained by reading parameters memorized in the coding or decoding step.

4. The method according to Claim 2, **characterized in that** the coefficients of the linear prediction filter are obtained by analysis from at least the samples of the current block.

5. The method according to Claim 1, **characterized in that** the linear prediction is carried out on an audio frequency signal on which a pre-emphasis processing has been carried out.

6. The method according to Claim 1, **characterized in that** the adaptive linear prediction is a prediction from one of the following methods:

- short-term linear prediction;
- long-term linear prediction;
- combination of short-term linear prediction and long-term linear prediction;
- erased frame concealment process.

7. A device for resampling an audio frequency signal in an audio frequency signal coder or decoder, **characterized in that** it comprises:

- an adaptive linear prediction module (301) capable of determining, for a signal block, a number of future signal samples defined as a function of a chosen resampling delay;
- a construction module (304) of a resampling support vector from at least the samples of the current signal block and the determined samples of future signal;
- a resampling filter (305) applied on the samples of the resampling support vector.

8. The device according to Claim 7, **characterized in that** the adaptive linear prediction module cooperates with an analysis module (302b) by prediction comprised in the coding or decoding module by prediction, of the coder or decoder.

9. An audio-frequency signal coder **characterized in that** it comprises at least one resampling device according to one of Claims 7 or 8.

10. The coder according to Claim 9, **characterized in that** it comprises a resampling device using at least two resampling filters having different delays, at least one of the filters being implemented in accordance with the method of Claim 1, wherein the determination of the number of future signal samples is a function of the delay difference of the two resampling filters used.

11. An audio-frequency signal decoder **characterized in that** it comprises at least one resampling device according to one of Claims 7 or 8.

12. The decoder according to Claim 11, **characterized in that** it comprises a resampling device using at least two resampling filters having different delays, at least one of the filters being implemented in accordance with the method of Claim 1, wherein the determination of the number of future signal samples is a function of the delay difference of the two resampling filters used.

13. A computer program comprising code instructions for implementing the steps of the resampling method according to one of Claims 1 to 6, when these instructions are executed by a processor.

**14.** A processor-readable storage medium, on which a computer program is stored comprising code instructions for the execution of the steps of the resampling method according to one of Claims 1 to 6.

**Fig. 1 (état de l'art)**

Fig. 2 (état de l'art)

Fig.3

21

EP 3 053 163 B1

buf_In

E401 — Pred buf_fut

E402 — Vect.

E403 — Fir filt

buf_Out

mem

E405

**Fig.4a**

buf_In

Det preemph fact

E406

E407 — preemph

E401 — Pred buf_fut

E402 — Vect.

E408 — deemph

E403 — Fir filt

buf_Out

mem

E405

**Fig.4b**

**Fig.5a**

**Fig.5b**

EP 3 053 163 B1

**Fig.6**

EP 3 053 163 B1

**Fig.7a**

**Fig.7b**

**Fig.7c**

**Fig.7d**

**Fig.7e**

**Fig.7f**

**Fig.7g**

**Fig.7h**

**Fig.7i**

**Fig.7j**

**Fig.7k**

**Fig.7l**

**Fig.8a**

**Fig.8b**

**Fig.8c**

**Fig.9**

**Fig.10**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2013096913 A1
- WO 2012103686 A1
- EP 1316087 A

**Littérature non-brevet citée dans la description**

- **R.W. SCHAFER ; L.R. RABINER.** A Digital Signal Processing Approach to Interpolation. *Proceedings of the IEEE,* Juin 1973, vol. 61 (6), 692-702
- **P.A. REGALIA ; S.K. MITRA ; P.P. VAIDYANATH-AN.** The Digital All-Pass Filter: A Versatile Signal Processing Building Block. *Proceedings of the IEEE,* Janvier 1988, vol. 76 (1